# EUROPEAN PATENT APPLICATION

(11) **EP 4 383 326 A1**
(43) Date of publication of application: **12.06.2024**
(21) Application number: 21953799.0
(22) Date of filing: 20.08.2021
(51) Int. Cl.: H01L 23/31

(54) **CHIP PACKAGING STRUCTURE, FABRICATION METHOD THEREFOR, AND ELECTRONIC DEVICE**

(71) Applicant: Huawei Technologies Co., Ltd., Shenzhen, Guangdong 518129 (CN)
(72) Inventor: CHIANG, Shanghsuan, Shenzhen, Guangdong 518129 (CN); ZHAO, Nan, Shenzhen, Guangdong 518129 (CN)
(74) Representative: Pfenning, Meinig & Partner mbB
(86) International application number: PCT/CN2021/113802
(87) International publication number: WO 2023/019558

(57) **Abstract**

This application provides a chip packaging structure and a manufacturing method thereof, and an electronic device. The chip packaging structure includes a re-distribution layer, a plastic packaging structure wrapping at least two dies, and a support carrier board. The plastic packaging structure is fixed on the re-distribution layer. The support carrier board is fixed on a side that is of the plastic packaging structure and that is away from the re-distribution layer. The support carrier board includes a non-metal material. The support carrier board is rigidly connected to each die in the plastic packaging structure. The support carrier board is manufactured by using the non-metal material, so that the support carrier board can match a rigid bonding layer that is not affected by a temperature, to be rigidly connected to the die. In this way, in a plastic packaging craft process, the die can withstand a fluid pressure of a plastic packaging material, shift of the die is reduced, and craft difficulty of the chip packaging structure is reduced. After the chip packaging structure is manufactured, the support carrier board is reserved inside the chip packaging structure. Because the support carrier board has a structural support function for the die, reliability of the chip packaging structure can be improved.

## Description

### TECHNICAL FIELD

This application relates to the field of chip technologies, and in particular, to a chip packaging structure and a manufacturing method thereof, and an electronic device.

### BACKGROUND

With continuous development of information technologies, an electronic device is gradually miniaturized, and more functions need to be integrated into smaller space. Therefore, a chip packaging technology is a key solution. A plurality of dies (dies) are packaged in one chip packaging structure. Therefore, high integration of functions can be implemented, but a size of the chip packaging structure is larger.

As the size of the chip packaging structure increases, the chip packaging technology faces challenges in a plurality of aspects such as a craft, stress, heat dissipation, a material, and reliability. For example, when multi-die packaging is performed on the plurality of dies by using a re-distribution layer (Re-Distribution Layer, RDL), the plurality of dies are physically connected to the re-distribution layer, and a plastic packaging layer is filled between adjacent dies. In a manufacturing process, the plurality of dies need to be fixed on a carrier board, and the plastic packaging layer is formed on the carrier board. Then, the carrier board is removed, and the re-distribution layer is formed on each die. In a conventional technology, the carrier board is manufactured by using a metal material, and the carrier board of the metal material needs to match a pyrolytic bonding film, to be bonded to the die. In a craft process of forming the plastic packaging layer, because the pyrolytic bonding film on a surface of the carrier board is soft, and a temperature in the craft process affects the pyrolytic bonding film, stability of a connection between the die and the carrier board deteriorates. As a result, under impact of a fluid pressure of a plastic packaging material, a lateral shear force is generated on a side surface of the die. Consequently, the die shifts, alignment of subsequent exposure is inaccurate, and finally, electrical performance of the die fails. In addition, in a subsequent reliability detection process, the plastic packaging layer between the dies may crack and fail due to concentration of die-to-die (Die-to-Die) stress.

### SUMMARY

This application provides a chip packaging structure and a manufacturing method thereof, and an electronic device, to reduce craft difficulty of the chip packaging structure and improve reliability of the chip packaging structure.

According to a first aspect, this application provides a chip packaging structure. The chip packaging structure may include a re-distribution layer, a plastic packaging structure wrapping at least two dies, and a support carrier board. The plastic packaging structure is fixed on the re-distribution layer. The support carrier board is fixed on a side that is of the plastic packaging structure and that is away from the re-distribution layer. The support carrier board includes a non-metal material. The support carrier board is rigidly connected to each die in the plastic packaging structure.

In a conventional technology, a carrier board is manufactured by using a metal material, and the carrier board of the metal material needs to match a pyrolytic bonding film, to be bonded to a die. In a craft process of forming the plastic packaging layer, because the pyrolytic bonding film on a surface of the carrier board is soft, and a temperature in the craft process affects the pyrolytic bonding film, stability of a connection between the die and the carrier board deteriorates. As a result, under impact of a fluid pressure of a plastic packaging material, a lateral shear force is generated on a side surface of the die. Consequently, the die shifts. In this embodiment of this application, the support carrier board is manufactured by using the non-metal material, so that the support carrier board can match a rigid bonding layer that is not affected by a temperature, to be rigidly connected to the die. For example, a material of the support carrier board may be glass, and the support carrier board may be rigidly connected to the die by using a photolytic bonding film. In addition, the photolytic bonding film is debonded only when the photolytic bonding film is irradiated by ultraviolet light, and a high temperature in the craft process does not affect connection stability of the photolytic bonding film. In this way, in the plastic packaging craft process, the die can withstand the fluid pressure of the plastic packaging material, and shift of the die is reduced.

In addition, in this embodiment of this application, after the chip packaging structure is manufactured, the support carrier board is reserved inside the chip packaging structure. Because the support carrier board has a structural support function for the die, internal stress generated due to factors such as mismatch between coefficients of thermal expansion of different materials and thermal expansion and cold contraction can be reduced, and a problem that the plastic packaging layer between the dies cracks due to excessively large internal stress of the chip packaging structure is avoided. In addition, the support carrier board is disposed in the chip packaging structure, so that rigidity of the chip packaging structure can be improved, the chip packaging structure does not warp, and reliability of the chip packaging structure is further improved. Therefore, the support carrier board is disposed in the chip packaging structure, so that craft difficulty of the chip packaging structure can be reduced, and the reliability of the chip packaging structure is improved. After limitations in aspects such as a craft and stress are overcome, more dies may be packaged by using the re-distribution layer.

Optionally, in this embodiment of this application, the die may include a semiconductor substrate and a distribution layer that is located on the semiconductor substrate. The semiconductor substrate may include a semiconductor material such as silicon (Si), germanium (Ge), gallium arsenide, indium phosphide, gallium nitride, silicon carbide, or gallium oxide. The support carrier board may include a material such as silicon (Si) or silicon dioxide (SiO₂). An interfacial thermal resistance of the material of the support carrier board is low, and a heat dissipation effect of the chip packaging structure is not affected.

During specific implementation, the material of the support carrier board may be set to a material whose coefficient of thermal expansion is close to that of the semiconductor substrate. For example, the material of the support carrier board and the material of the semiconductor substrate may be both silicon. In this way, a connection between the support carrier board and the semiconductor substrate can be firmer, and a warping phenomenon caused by match of coefficients of thermal expansion is avoided. A reason is as follows: If a difference between a coefficient of thermal expansion of the support carrier board and a coefficient of thermal expansion of the semiconductor substrate is large, in a bonding craft process, under an effect of a high temperature, an expansion degree of the support carrier board and an expansion degree of the semiconductor substrate are different. After the bonding craft is completed and the temperature is restored to a room temperature, the support carrier board and the semiconductor substrate shrink to different degrees. As a result, a bonding location between the support carrier board and the semiconductor substrate changes, and consequently, a bonding effect between the support carrier board and the semiconductor substrate is poor. In addition, the chip packaging structure warps due to a force between the support carrier board and the semiconductor substrate.

In this embodiment of this application, the support carrier board may be of a single-layer structure. To be specific, the support carrier board may include only one layer of support substrate. Alternatively, the support carrier board may be of a multi-layer structure. To be specific, the support carrier board may include at least two support substrates disposed in a stacked manner. Coefficients of thermal expansion of different support substrates in the support carrier board are different, and a difference between an average coefficient of thermal expansion of the support substrates in the support carrier board and a coefficient of thermal expansion of the die is less than a specified value. In this way, the average coefficient of thermal expansion of the support carrier board may be close to the coefficient of thermal expansion of the die, to prevent the chip packaging structure from warping because the coefficient of thermal expansion of the support carrier board mismatches the coefficient of thermal expansion of the die.

In a possible implementation, the chip packaging structure may further include a bonding layer located on a surface that is of the support carrier board and that faces the plastic packaging structure. Each die in the plastic packaging structure is bonded to the support carrier board by using the bonding layer. The bonding layer is disposed, and the die is bonded to the surface of the support carrier board, so that the die can be firmly fixed on the surface of the support carrier board. In addition, the die is firmly fixed on the support carrier board, so that the support carrier board can further protect the die under pressure.

During specific implementation, the bonding layer may include a metal material or an oxide material. The bonding layer is manufactured by using the metal material or the oxide material, so that the formed bonding layer is rigid, and the die can be rigidly connected to the support carrier board. For example, the oxide material may be a silicon oxide material. Certainly, the bonding layer may alternatively include another material. This is not limited herein. In an actual craft process, the die may be bonded to the surface of the support carrier board by using a craft such as metal eutectic bonding, fusion bonding, or hybrid bonding. Certainly, the die may alternatively be fixed on the surface of the support carrier board in another manner. This is not limited herein.

During actual application, an alignment mark for marking a location of the die may be disposed on the surface that is of the support carrier board and that faces the plastic packaging structure. In this way, in a process in which the die is bonded to the surface of the support carrier board, the die can be more accurately bonded to a corresponding coordinate location by using the alignment mark, to improve precision of die bonding.

In another embodiment of this application, the chip packaging structure may further include an adhesive layer located on a surface that is of the support carrier board and that faces the die. Each die is adhered to the support carrier board by using the adhesive layer. In other words, the bonding layer may be replaced with the adhesive layer, and the die may also be firmly fixed on the surface of the support carrier board by disposing the adhesive layer. Optionally, the adhesive layer may include a chip adhesive film, a debonding adhesive, or another material. This is not limited herein. The adhesive layer is manufactured by using the chip adhesive film or the debonding adhesive, so that the formed adhesive layer is rigid, and the die can be rigidly connected to the support carrier board.

In a possible implementation, the plastic packaging structure may include a plastic packaging layer filled between the support carrier board and the re-distribution layer. The plastic packaging layer wraps each die, and may have a function of filling protection. Optionally, the plastic packaging layer may include epoxy molding compound. Certainly, the plastic packaging layer may alternatively include another material. This is not limited herein.

When a structure of the plastic packaging layer is specifically disposed, the plastic packaging layer fills a gap between adjacent dies of the at least two dies. Because the support carrier board has the structural support function for the die, the internal stress generated due to the factors such as the mismatch between coefficients of thermal expansion of different materials and the thermal expansion and cold contraction can be reduced, so that a size of the gap between the adjacent dies is basically unchanged. Therefore, the plastic packaging layer in the gap between the dies and the die do not crack, and structural reliability of the chip packaging structure is improved. In addition, the plastic packaging layer wraps outer edges of the at least two dies. In other words, the gap between the adjacent dies is filled with the plastic packaging layer, and an outer edge of a die that is close to an outer side in the chip packaging structure is also wrapped by the plastic packaging layer. In this way, the plastic packaging layer can reduce stress at an edge of the chip packaging structure, and further improve the structural reliability of the chip packaging structure.

In a possible implementation, a shape and a size of an external profile of the plastic packaging layer are consistent with a shape and a size of an external profile of the support carrier board. In other words, the plastic packaging layer can fill an edge location of the support carrier board, and can have a function of greatly cushioning stress.

In a possible implementation, a plurality of conductive columns are disposed on a surface of each die in the plastic packaging structure. Each die is electrically connected to the re-distribution layer by using the plurality of conductive columns. The conductive column may include a metal material. For example, the conductive column may be a copper column. Certainly, another material with good conductive performance may alternatively be used for the conductive column. This is not limited herein.

In a possible implementation, the chip packaging structure may further include a substrate. A plurality of solder balls are disposed on a surface that is of the re-distribution layer and that is away from the die. The re-distribution layer is electrically connected to the substrate by using the plurality of solder balls.

In addition, the chip packaging structure may further include a protection cover disposed on the substrate. The protection cover is located on a side that is of the support carrier board and that is away from the substrate, and there is a gap between the protection cover and the support carrier board. Therefore, the protection cover may have a function of protection and heat dissipation.

According to a second aspect, this application further provides an electronic device. The electronic device may include a circuit board and any one of the foregoing chip packaging structures. The chip packaging structure is electrically connected to the circuit board. In this embodiment of this application, a support carrier board is disposed in the chip packaging structure, so that craft difficulty of the chip packaging structure can be reduced, and reliability of the chip packaging structure is improved. After limitations in aspects such as a craft and stress are overcome, more dies may be packaged by using a re-distribution layer. Therefore, the electronic device including the chip packaging structure has a high integration level and good performance.

According to a third aspect, this application further provides a manufacturing method of a chip packaging structure. The manufacturing method may include:
providing at least two dies and a support carrier board, where the support carrier board includes a non-metal material;
rigidly connecting each of the at least two dies to the support carrier board;
forming, by using a plastic packaging material, a plastic packaging layer that wraps the at least two dies, to form, on a surface of the support carrier board, a plastic packaging structure that wraps the at least two dies; and
forming a re-distribution layer on a side that is of the plastic packaging structure and that is away from the support carrier board.

In this embodiment of this application, the support carrier board is manufactured by using the non-metal material, so that the support carrier board can match a rigid bonding layer that is not affected by a temperature, to be rigidly connected to the die. For example, a material of the support carrier board may be glass (SiO₂), and the support carrier board may be rigidly connected to the die by using a photolytic bonding film. In addition, the photolytic bonding film is debonded only when the photolytic bonding film is irradiated by ultraviolet light, and a high temperature in the craft process does not affect connection stability of the photolytic bonding film. In this way, in the plastic packaging craft process, the die can withstand the fluid pressure of the plastic packaging material, and shift of the die is reduced. Because the support carrier board has a structural support function for the die, internal stress generated due to factors such as mismatch between coefficients of thermal expansion of different materials and thermal expansion and cold contraction can be reduced, and a problem that the plastic packaging layer between the dies cracks due to excessively large internal stress of the chip packaging structure is avoided. Therefore, the support carrier board is disposed in the chip packaging structure, so that craft difficulty of the chip packaging structure can be reduced, and reliability of the chip packaging structure is improved.

In a possible implementation, the rigidly connecting each of the at least two dies to the support carrier board may include: forming a bonding layer on a surface on a side of the support carrier board by using a metal material or an oxide material. For example, the oxide material may be a silicon oxide material. Then, each die is bonded to the support carrier board by using the bonding layer. In an actual craft process, the die may be bonded to the surface of the support carrier board by using a craft such as metal eutectic bonding, fusion bonding, or hybrid bonding. Certainly, the die may alternatively be fixed on the surface of the support carrier board in another manner. This is not limited herein.

During actual application, an alignment mark for marking a location of the die may be disposed on the surface that is of the support carrier board and that faces the die. In this way, in a process in which the die is bonded to the surface of the support carrier board, the die can be more accurately bonded to a corresponding coordinate location by using the alignment mark, to improve precision of die bonding.

In another embodiment of this application, the rigidly connecting each of the at least two dies to the support carrier board may include: forming an adhesive layer on a surface on a side of the support carrier board by using a chip adhesive film or a debonding adhesive; and adhering each die to the support carrier board by using the adhesive layer. In other words, the bonding layer may be replaced with the adhesive layer, and the die may also be firmly fixed on the surface of the support carrier board by disposing the adhesive layer. Optionally, the adhesive layer may include a chip adhesive film, a debonding adhesive, or another material. This is not limited herein.

In a possible implementation, the forming, by using a plastic packaging material, a plastic packaging layer that wraps the at least two dies may include:
forming the plastic packaging layer on a surface that is of the support carrier board and that has the die, where the plastic packaging layer fills a gap between adjacent dies of the at least two dies, and the plastic packaging layer wraps outer edges of the at least two dies. In other words, the gap between the adjacent dies is filled with the plastic packaging layer, and an outer edge of a die that is close to an outer side in the chip packaging structure is also wrapped by the plastic packaging layer. In this way, the plastic packaging layer can reduce stress at an edge of the chip packaging structure, and further improve structural reliability of the chip packaging structure.

In this embodiment of this application, a plurality of conductive columns are disposed on an active surface of each die in the chip packaging structure, and the plastic packaging layer fills a gap between adjacent conductive columns. After the plastic packaging layer is formed, the method may further include: removing the plastic packaging layer from the surface of each die in the plastic packaging structure, to expose the conductive column on the surface of the die, and aligning a surface of the conductive column with a surface of the plastic packaging layer, so that a surface of the plastic packaging structure is flat. Then, each film layer of the re-distribution layer may be directly formed on the surface of the die. Therefore, the active surface of the die does not need to be welded to a surface of the re-distribution layer, so that a size of the conductive column is not limited by a welding craft. A conductive column of a smaller size may be disposed on the active surface of the die, and the conductive columns may be disposed more densely. For example, a distance between the conductive columns may be less than 20 µm, to improve integration of the chip packaging structure.

During specific implementation, to prevent the die from warping after being rigidly connected to the support carrier board 3, in a manufacturing craft process, a thickness of the die and a thickness of the support carrier board need to satisfy specified requirements. If the actual thickness of the die and the actual thickness of the support carrier board are different from a thickness required in a manufacturing craft, before the die is fixed on the surface of the support carrier board, the thickness of the die and the thickness of the support carrier board may be adjusted by using a thinning craft. The thinning craft includes but is not limited to a grinding craft. In addition, after the die is fixed on the support carrier board, the method may further include: thinning, by using the thinning craft, a surface that is of the support carrier board and that is away from the die, to reduce a volume of the support carrier board, and ensure that a subsequently mounted protection cover can accommodate components such as the support carrier board and the die. The thinning craft includes but is not limited to the grinding craft.

In a possible implementation, after the re-distribution layer is formed on a side of the active surface of the die, the method may further include: providing a substrate, and fixing the re-distribution layer on the substrate, where a surface that is of the re-distribution layer and that is away from the die faces the substrate. In this way, the re-distribution layer is electrically connected to the substrate. After the re-distribution layer is fixed on the substrate, the method may further include: mounting the protection cover on the substrate. The protection cover is located on a side that is of the support carrier board and that is away from the substrate, and there is a gap between the protection cover and the support carrier board. Therefore, the protection cover may have a function of protection and heat dissipation.

In another embodiment of this application, after the forming a re-distribution layer, the method may further include: removing the support carrier board by using a debonding craft. The debonding craft includes but is not limited to the grinding craft. In a craft process in which the plastic packaging layer, the re-distribution layer, and the like are formed, the support carrier board may have a function of fixing the die and supporting. After the re-distribution layer is formed, the support carrier board may be removed, to reduce a total thickness of the chip packaging structure and satisfy a requirement for lightness and thinness of the chip packaging structure. After the support carrier board is removed, the method may further include: fixing the re-distribution layer on the substrate, where the surface that is of the re-distribution layer and that is away from the die faces the substrate; and then mounting the protection cover on the substrate, where the protection cover is located on a side that is of the die and that is away from the substrate, and there is a gap between the protection cover and the die. Therefore, the protection cover may have the function of protection and heat dissipation.

### BRIEF DESCRIPTION OF DRAWINGS

FIG. 1 is a schematic diagram of a cross-sectional structure of a chip packaging structure according to an embodiment of this application;
FIG. 2 is a schematic diagram of partial enlargement of a die in FIG. 1;
FIG. 3a is a schematic diagram of enlargement of a circle Q1 in FIG. 1;
FIG. 3b is a schematic diagram of enlargement of a circle Q2 in FIG. 1;
FIG. 4 is another schematic diagram of a cross-sectional structure of a chip packaging structure according to an embodiment of this application;
FIG. 5 is a schematic diagram of a structure of an electronic device according to an embodiment of this application;
FIG. 6 is a flowchart of a manufacturing method of the chip packaging structure according to an embodiment of this application; and
FIG. 7 to FIG. 14 are schematic diagrams of structures corresponding to steps in the manufacturing method.

### Reference numerals:

100-chip packaging structure; 10-substrate; 11-re-distribution layer; 1000-plastic packaging structure; 12-die; 121-semiconductor substrate; 122-distribution layer; 123-conductive column; 13-support carrier board; 14-bonding layer; 15-plastic packaging layer; 16 and 17-pad; 18-protection cover; 200-circuit board; S1-active surface; S2-passive surface.

### DESCRIPTION OF EMBODIMENTS

To make the objectives, technical solutions, and advantages of this application clearer, the following further describes this application in detail with reference to the accompanying drawings.

It should be noted that same reference numerals in the accompanying drawings of this application represent same or similar structures. Therefore repeated descriptions thereof are omitted. Expressions of locations and directions in this application are described by using the accompanying drawings as an example. However, changes may also be made as required, and all the changes fall within the protection scope of this application. The accompanying drawings in this application are merely used to illustrate relative location relationships and do not represent an actual scale.

A chip packaging structure provided in embodiments of this application may be applied to various electronic devices, for example, may be applied to electronic devices such as a smartphone, a smart television, a smart television set-top box, a personal computer (personal computer, PC), a wearable device, and a smart broadband. It should be noted that the chip packaging structure provided in embodiments of this application is intended to include but is not limited to application to these and any other suitable type of electronic devices. The chip packaging structure in embodiments of this application may use a plurality of packaging forms. For example, packaging may be performed in a manner such as a 2.5 dimensional fan-out package (2.5 Dimensional Fan-Out Package, 2.5D FOP), a 2.5 dimensional through silicon via (2.5 Dimensional Through Silicon Via, 2.5D TSV) package, a silicon bridge (Si bridge) package, or a three dimensional (3 Dimensional) package. Certainly, the chip packaging structure may alternatively use another packaging form. This is not limited herein.

A chip packaging structure, a manufacturing method thereof, and an electronic device that are provided in this application are described in detail below with reference to the accompanying drawings.

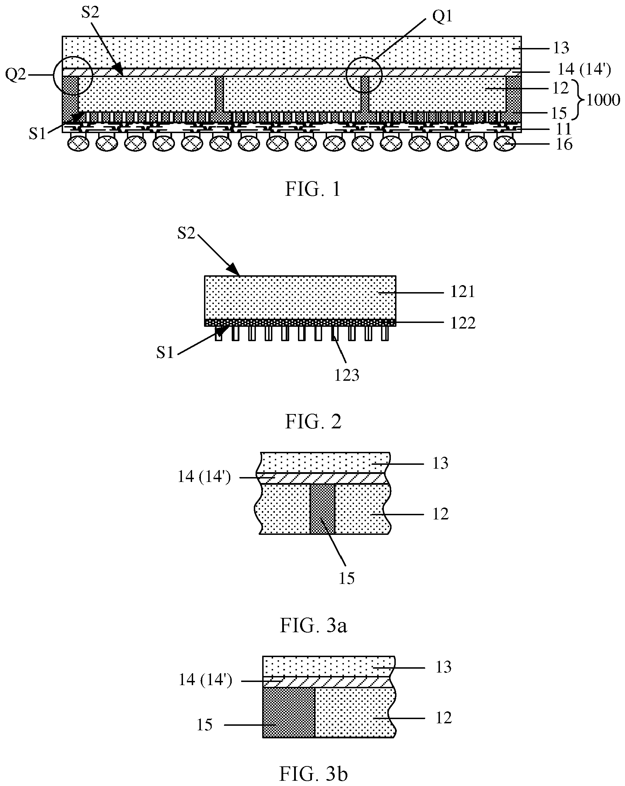

FIG. 1 is a schematic diagram of a cross-sectional structure of a chip packaging structure according to an embodiment of this application. As shown in FIG. 1, the chip packaging structure provided in this embodiment of this application may include a re-distribution layer 11, a plastic packaging structure 1000 wrapping at least two dies 12, and a support carrier board 13. The plastic packaging structure 1000 is fixed on the re-distribution layer 11. The support carrier board 13 is fixed on a side that is of the plastic packaging structure 1000 and that is away from the re-distribution layer 11. The support carrier board 13 includes a non-metal material. The support carrier board 13 is rigidly connected to each die 12 in the plastic packaging structure 1000.

In a conventional technology, a carrier board is manufactured by using a metal material, and the carrier board of the metal material needs to match a pyrolytic bonding film, to be bonded to a die. In a craft process of forming a plastic packaging layer, because the pyrolytic bonding film on a surface of the carrier board is soft, and a temperature in the craft process affects the pyrolytic bonding film, stability of a connection between the die and the carrier board deteriorates. As a result, under impact of a fluid pressure of a plastic packaging material, a lateral shear force is generated on a side surface of the die. Consequently, the die shifts. In this embodiment of this application, the support carrier board 13 is manufactured by using the non-metal material, so that the support carrier board 13 can match a rigid bonding layer that is not affected by a temperature, to be rigidly connected to the die 12. For example, a material of the support carrier board 13 may be glass, and the support carrier board 13 may be rigidly connected to the die 12 by using a photolytic bonding film. In addition, the photolytic bonding film is debonded only when the photolytic bonding film is irradiated by ultraviolet light, and a high temperature in the craft process does not affect connection stability of the photolytic bonding film. In this way, in the plastic packaging craft process, the die 12 can withstand the fluid pressure of the plastic packaging material, and shift of the die 12 is reduced.

In addition, in this embodiment of this application, after the chip packaging structure is manufactured, the support carrier board 13 is reserved inside the chip packaging structure. Because the support carrier board 13 has a structural support function for the die 12, internal stress generated due to factors such as mismatch between coefficients of thermal expansion of different materials and thermal expansion and cold contraction can be reduced, and a problem that a plastic packaging layer 15 between the dies 12 cracks due to excessively large internal stress of the chip packaging structure is avoided. In addition, the support carrier board 13 is disposed in the chip packaging structure, so that rigidity of the chip packaging structure can be improved, the chip packaging structure does not warp, and reliability of the chip packaging structure is further improved. Therefore, the support carrier board 13 is disposed in the chip packaging structure, so that craft difficulty of the chip packaging structure can be reduced, and the reliability of the chip packaging structure is improved. After limitations in aspects such as a craft and stress are overcome, more dies 12 may be packaged by using the re-distribution layer 11. In FIG. 1, an example in which the chip packaging structure includes three dies 12 is used. During actual application, a quantity of dies 12 may be set based on an actual situation. This is not limited herein.

In this embodiment of this application, the die may be a wafer, and is an unpackaged integrated circuit body manufactured by using a semiconductor material. A given function of the integrated circuit is implemented in the semiconductor material. Optionally, FIG. 2 is a schematic diagram of partial enlargement of the die in FIG. 1. As shown in FIG. 1 and FIG. 2, the die 12 may include a semiconductor substrate 121 and a distribution layer 122 that is located on the semiconductor substrate 121. A semiconductor device such as a transistor may be formed on the semiconductor substrate 121. Various functional circuits may be disposed in the distribution layer 122. The functional circuits on the distribution layer 122 and the semiconductor device on the semiconductor substrate 121 may form a complete chip circuit structure. The die 12 may include an active surface S 1 and a passive surface S2. The active surface S1 of the die 12 may be a side including the distribution layer 122, and the passive surface S2 of the die 12 may be a side including the semiconductor substrate 121. The support carrier board 13 is rigidly connected to a surface that is of the semiconductor substrate 121 and that is away from the distribution layer 122. In other words, the support carrier board 13 is rigidly connected to a surface on a side of the passive surface S2 of the die 12. In this way, the active surface S1 of the die 12 can be more easily electrically connected to the re-distribution layer 11.

Optionally, still refer to FIG. 1 and FIG. 2. In this embodiment of this application, the semiconductor substrate 121 may include a semiconductor material such as silicon (Si), germanium (Ge), gallium arsenide, indium phosphide, gallium nitride, silicon carbide, or gallium oxide. The support carrier board 13 may include a material such as silicon (Si) or silicon dioxide (SiO₂). An interfacial thermal resistance of the material of the support carrier board 13 is low, and a heat dissipation effect of the chip packaging structure is not affected.

During specific implementation, the material of the support carrier board 13 may be set to a material whose coefficient of thermal expansion is close to that of the semiconductor substrate 121. For example, the material of the support carrier board 13 and the material of the semiconductor substrate 121 may be both silicon. In this way, a connection between the support carrier board 13 and the semiconductor substrate 121 can be firmer, and a warping phenomenon caused by match of coefficients of thermal expansion is avoided. A reason is as follows: If a difference between a coefficient of thermal expansion of the support carrier board 13 and a coefficient of thermal expansion of the semiconductor substrate 121 is large, in a bonding craft process, under an effect of a high temperature, an expansion degree of the support carrier board 13 and an expansion degree of the semiconductor substrate 121 are different. After the bonding craft is completed and the temperature is restored to a room temperature, the support carrier board 13 and the semiconductor substrate 121 shrink to different degrees. As a result, a bonding location between the support carrier board 13 and the semiconductor substrate 121 changes, and consequently, a bonding effect between the support carrier board 13 and the semiconductor substrate 121 is poor. In addition, the chip packaging structure warps due to a force between the support carrier board 13 and the semiconductor substrate 121.

In this embodiment of this application, the support carrier board 13 may be of a single-layer structure. To be specific, the support carrier board 13 may include only one layer of support substrate. Alternatively, the support carrier board 13 may be of a multi-layer structure. To be specific, the support carrier board 13 may include at least two support substrates disposed in a stacked manner. Coefficients of thermal expansion of different support substrates in the support carrier board 13 are different, and a difference between an average coefficient of thermal expansion of the support substrates in the support carrier board and a coefficient of thermal expansion of the die 12 is less than a specified value. In this way, the average coefficient of thermal expansion of the support carrier board 13 may be close to the coefficient of thermal expansion of the die 12, to prevent the chip packaging structure from warping because the coefficient of thermal expansion of the support carrier board 13 mismatches the coefficient of thermal expansion of the die 12.

During specific implementation, to prevent the die 12 from warping after being rigidly connected to the support carrier board 13, in a manufacturing craft process, a thickness of the die 12 and a thickness of the support carrier board 13 need to satisfy specified requirements. If the actual thickness of the die 12 and the actual thickness of the support carrier board 13 are different from a thickness required in a manufacturing craft, before the die 12 is fixed on the surface of the support carrier board 13, the thickness of the die 12 and the thickness of the support carrier board 13 may be adjusted by using a thinning craft. The thinning craft includes but is not limited to a grinding craft. In addition, after the die 12 is fixed on the support carrier board 13, a surface that is of the support carrier board 13 and that is away from the die 12 may further be thinned by using the thinning craft, to reduce a volume of the support carrier board 13, and ensure that a subsequently mounted protection cover can accommodate components such as the support carrier board 13 and the die 12. The thinning craft includes but is not limited to the grinding craft.

Still refer to FIG. 1. The chip packaging structure provided in this embodiment of this application may further include a bonding layer 14 located on a surface that is of the support carrier board 13 and that faces the plastic packaging structure 1000. Each die 12 in the plastic packaging structure 1000 is bonded to the support carrier board 13 by using the bonding layer 14. The die 12 is bonded to the surface of the support carrier board 13 by using the bonding layer 14, so that the die 12 can be firmly fixed on the surface of the support carrier board 13. In addition, the die 12 is firmly fixed on the support carrier board 13, so that the support carrier board 13 can further protect the die 12 under pressure.

During specific implementation, the bonding layer 14 may include a metal material or an oxide material. The bonding layer 14 is manufactured by using the metal material or the oxide material, so that the formed bonding layer 14 is rigid, and the die 12 can be rigidly connected to the support carrier board 13. For example, the oxide material may be a silicon oxide material. Certainly, the bonding layer 14 may alternatively include another material. This is not limited herein. In an actual craft process, the die 12 may be bonded to the surface of the support carrier board 13 by using a craft such as metal eutectic bonding (metal bonding), fusion bonding (fusion bonding), or hybrid bonding (hybrid bonding). Certainly, the die 12 may alternatively be fixed on the surface of the support carrier board 13 in another manner. This is not limited herein.

During actual application, an alignment mark for marking a location of the die may be disposed on the surface that is of the support carrier board and that faces the plastic packaging structure. In this way, in a process in which the die is bonded to the surface of the support carrier board, the die can be more accurately bonded to a corresponding coordinate location by using the alignment mark, to improve precision of die bonding.

In another embodiment of this application, as shown in FIG. 1, the chip packaging structure may further include an adhesive layer 14' located on a surface that is of the support carrier board 13 and that faces the die 12. Each die 12 is adhered to the support carrier board 13 by using the adhesive layer 14'. In other words, the bonding layer 14 may be replaced with the adhesive layer 14', and the die 12 may also be firmly fixed on the surface of the support carrier board 13 by disposing the adhesive layer 14'. Optionally, the adhesive layer 14' may include a chip adhesive film, a debonding adhesive, or another material. This is not limited herein. The adhesive layer 14' is manufactured by using the chip adhesive film or the debonding adhesive, so that the formed adhesive layer 14' is rigid, and the die 12 can be rigidly connected to the support carrier board 13.

In addition, as shown in FIG. 1, the plastic packaging structure 1000 may include a plastic packaging layer 15 filled between the support carrier board 13 and the re-distribution layer 11. The plastic packaging layer 15 wraps each die 12, and may have a function of filling protection. Optionally, the plastic packaging layer 15 may include epoxy molding compound (epoxy molding compound, EMC). Certainly, the plastic packaging layer 15 may alternatively include another material. This is not limited herein.

FIG. 3a is a schematic diagram of enlargement of a circle Q 1 in FIG. 1. With reference to FIG. 1 and FIG. 3a, the plastic packaging layer 15 fills a gap between adjacent dies 12. In this embodiment of this application, the die 12 is fixed on the support carrier board 13. Because the support carrier board 13 has the structural support function for the die 12, the internal stress generated due to the factors such as the mismatch between coefficients of thermal expansion of different materials and the thermal expansion and cold contraction can be reduced, so that a size of the gap between the adjacent dies 12 is basically unchanged. Therefore, the plastic packaging layer 15 in the gap between the dies 12 and the die 12 do not crack, and structural reliability of the chip packaging structure is improved.

FIG. 3b is a schematic diagram of enlargement of a circle Q2 in FIG. 1. With reference to FIG. 1 and FIG. 3b, the plastic packaging layer 15 wraps outer edges of all the dies 12 in the chip packaging structure. In other words, the gap between the adjacent dies 12 is filled with the plastic packaging layer 15, and an outer edge of a die 12 that is close to an outer side in the chip packaging structure is also wrapped by the plastic packaging layer 15. In this way, the plastic packaging layer 15 can reduce stress at an edge of the chip packaging structure, and further improve the structural reliability of the chip packaging structure.

Optionally, as shown in FIG. 1, a shape and a size of an external profile of the plastic packaging layer 15 may be consistent with a shape and a size of an external profile of the support carrier board 13. In other words, the plastic packaging layer 15 can fill an edge location of the support carrier board 13, and can have a function of greatly cushioning stress.

As shown in FIG. 1 and FIG. 2, a plurality of conductive columns 123 are disposed on a surface of each die 12 in the plastic packaging structure 1000. Each die 12 is electrically connected to the re-distribution layer 11 by using the plurality of conductive columns 123. The conductive column 123 may include a metal material. For example, the conductive column 123 may be a copper column. Certainly, another material with good conductive performance may alternatively be used for the conductive column 123. This is not limited herein. Because the plurality of conductive columns 123 are disposed on the surface of the die 12, in an actual manufacturing process, the plastic packaging layer 15 may fill a gap between adjacent conductive columns 123, and a redundant plastic packaging material on the surface of the die 12 may be removed by using the grinding craft, to expose the conductive columns 123 on the surface of the die 12, and a surface of the conductive columns 123 is aligned with a surface of the plastic packaging layer 15, so that a surface of the plastic packaging structure 1000 is flat. Then, each film layer of the re-distribution layer 11 may be directly formed on the active surface S1 of the die 12. Therefore, the active surface S1 of the die 12 does not need to be welded to a surface of the re-distribution layer 11, so that a size of the conductive column 123 is not limited by a welding craft. A conductive column 123 of a smaller size may be disposed on the active surface S1 of the die 12, and the conductive columns 123 may be disposed more densely. For example, a distance between the conductive columns 123 may be less than 20 µm, to improve integration of the chip packaging structure.

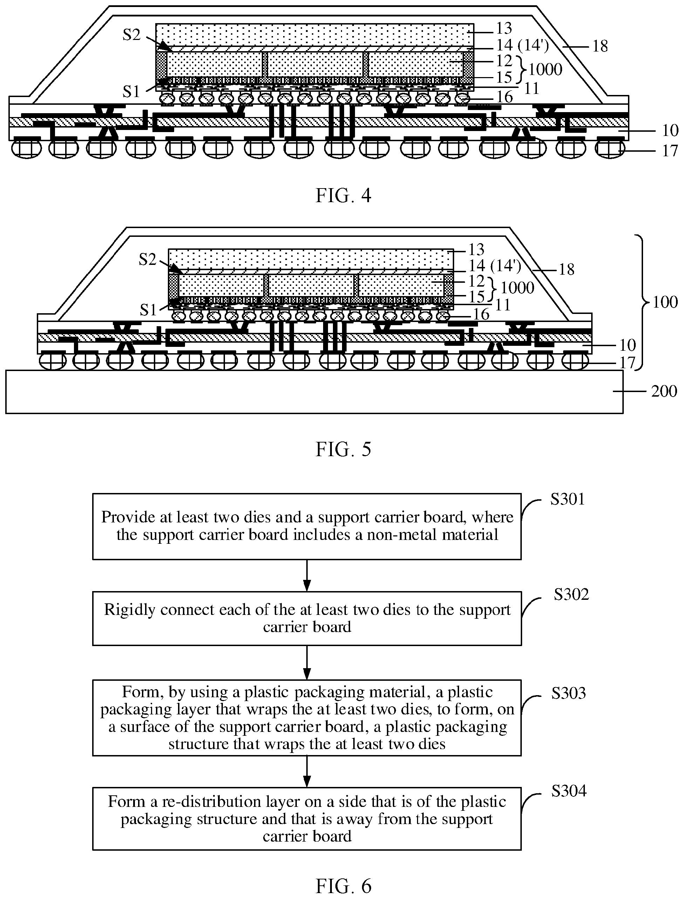

FIG. 4 is another schematic diagram of a cross-sectional structure of a chip packaging structure according to an embodiment of this application. As shown in FIG. 4, the chip packaging structure in this embodiment of this application may further include a substrate 10. A plurality of solder balls 16 are disposed on a surface that is of the re-distribution layer 11 and that is away from the die 12. The re-distribution layer 11 is electrically connected to the substrate 10 by using the plurality of solder balls 16.

In a conventional technology, coefficients of thermal expansion of the die 12, the re-distribution layer 11, and the substrate 10 are different, expansion degrees of the die 12, the re-distribution layer 11, and the substrate 10 are different when the die 12, the re-distribution layer 11, and the substrate 10 are heated, and a force generated by the substrate 10 and the re-distribution layer 11 on the die 12 easily causes shifting of the die 12. As a result, the gap between the adjacent dies 12 increases, and consequently, a crack is generated between a side surface of the die 12 and the plastic packaging layer 15. The crack extends to the re-distribution layer 11, and affects reliability of a signal line in the re-distribution layer 11. In addition, because the gap between the adjacent dies 12 increases, transverse traction is also generated on the re-distribution layer 11. As a result, the signal line in the re-distribution layer 11 is broken, and the solder ball on the surface of the re-distribution layer 11 is easily detached from the substrate 10. Consequently, performance of the chip packaging structure is affected.

Still refer to FIG. 4. In this embodiment of this application, the support carrier board 13 is disposed in the chip packaging structure, and the passive surface S2 of the die 12 is fixed on the support carrier board 13. In this way, when the substrate 10 is thermally expanded, due to the structural support function of the support carrier board 13, a force of the support carrier board 13 on the die 12 can offset at least a part of the force generated by the substrate 10 and the re-distribution layer 11 on the die 12, so that the gap between the dies 12 does not easily change, the crack is not easily generated between the side surface of the die 12 and the plastic packaging layer 15, and the die 12 does not generate the transverse traction on the re-distribution layer 11. Therefore, the re-distribution layer 11 is not easily damaged, and the solder ball 16 on the re-distribution layer 11 is not easily detached from the substrate 10. Therefore, due to the structural support function of the support carrier board 13, internal stress of the chip packaging structure can be reduced, and the structural reliability of the chip packaging structure is improved.

In addition, still refer to FIG. 4. The chip packaging structure may further include the protection cover 18 disposed on the substrate 10. The protection cover 18 is located on a side that is of the support carrier board 13 and that is away from the substrate 10, and there is a gap between the protection cover 18 and the support carrier board 13. Therefore, the protection cover 18 may have a function of protection and heat dissipation.

Based on a same technical concept, an embodiment of this application further provides an electronic device. FIG. 5 is a schematic diagram of a structure of an electronic device according to an embodiment of this application. As shown in FIG. 5, the electronic device may include a circuit board 200 and any one of the foregoing chip packaging structures 100. The chip packaging structure 100 is electrically connected to the circuit board 200. Optionally, in the chip packaging structure 100, a plurality of solder balls 17 may be disposed on a side that is of a substrate 10 and that is away from a die 12, and the substrate 10 may be welded to the circuit board by using the solder balls 17, so that the chip packaging structure 100 is electrically connected to the circuit board 200. The circuit board 200 may be a printed circuit board (printed circuit board, PCB). Certainly, the circuit board may alternatively be another type of circuit board. This is not limited herein.

In this embodiment of this application, a support carrier board is disposed in the chip packaging structure, so that craft difficulty of the chip packaging structure can be reduced, and reliability of the chip packaging structure is improved. After limitations in aspects such as a craft and stress are overcome, more dies may be packaged by using a re-distribution layer. Therefore, the electronic device including the chip packaging structure has a high integration level and good performance.

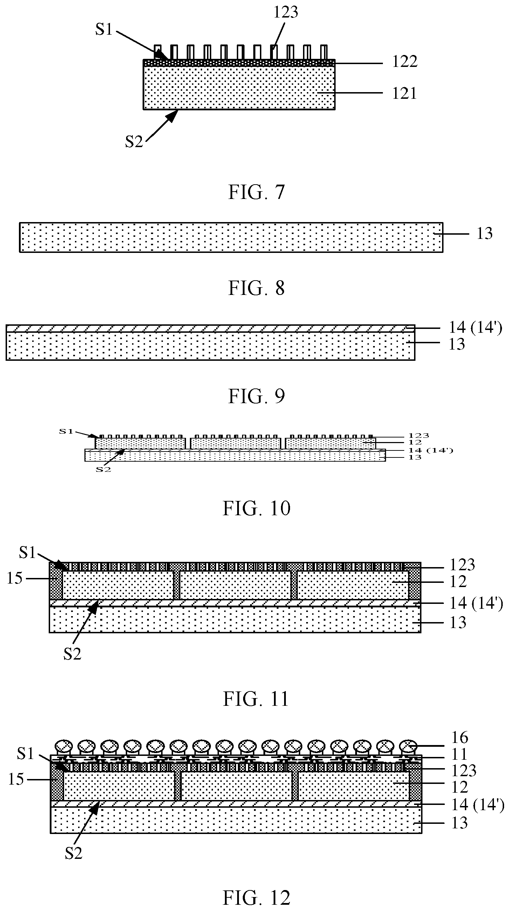

Based on a same technical concept, an embodiment of this application further provides a manufacturing method of the foregoing chip packaging structure. FIG. 6 is a flowchart of a manufacturing method of the chip packaging structure according to an embodiment of this application. FIG. 7 to FIG. 14 are schematic diagrams of structures corresponding to steps in the manufacturing method. The manufacturing method provided in this embodiment of this application is described in detail below with reference to the accompanying drawings.

As shown in FIG. 6, the manufacturing method may include the following steps.

S301: Provide at least two dies and a support carrier board, where the support carrier board includes a non-metal material.

S302: Rigidly connect each of the at least two dies to the support carrier board.

S303: Form, by using a plastic packaging material, a plastic packaging layer that wraps the at least two dies, to form, on a surface of the support carrier board, a plastic packaging structure that wraps the at least two dies.

S304: Form a re-distribution layer on a side that is of the plastic packaging structure and that is away from the support carrier board.

In this embodiment of this application, the support carrier board is manufactured by using the non-metal material, so that the support carrier board can match a rigid bonding layer that is not affected by a temperature, to be rigidly connected to the die. For example, a material of the support carrier board may be glass (SiO₂), and the support carrier board may be rigidly connected to the die by using a photolytic bonding film. In addition, the photolytic bonding film is debonded only when the photolytic bonding film is irradiated by ultraviolet light, and a high temperature in the craft process does not affect connection stability of the photolytic bonding film. In this way, in the plastic packaging craft process, the die can withstand the fluid pressure of the plastic packaging material, and shift of the die is reduced. Because the support carrier board has a structural support function for the die, internal stress generated due to factors such as mismatch between coefficients of thermal expansion of different materials and thermal expansion and cold contraction can be reduced, and a problem that the plastic packaging layer between the dies cracks due to excessively large internal stress of the chip packaging structure is avoided. Therefore, the support carrier board is disposed in the chip packaging structure, so that craft difficulty of the chip packaging structure can be reduced, and reliability of the chip packaging structure is improved.

In step S301, a structure of the die may be shown in FIG. 7. Each die 12 may include a semiconductor substrate 121 and a distribution layer 122 that is located on the semiconductor substrate 121. In addition, a plurality of conductive columns 123 are disposed on an active surface S1 of each die 12. The semiconductor substrate 121 in the die 12 may include a semiconductor material such as silicon (Si), germanium (Ge), gallium arsenide, indium phosphide, gallium nitride, silicon carbide, or gallium oxide. A structure of the support carrier board may be shown in FIG. 8. The support carrier board 13 may include a material such as silicon (Si) or silicon dioxide (SiO₂). An interfacial thermal resistance of the material of the support carrier board 13 is low, and a heat dissipation effect of the chip packaging structure is not affected.

During specific implementation, the material of the support carrier board 13 may be set to a material whose coefficient of thermal expansion is close to that of the semiconductor substrate 121. For example, the material of the support carrier board 13 and the material of the semiconductor substrate 121 may be both silicon. In this way, a connection between the support carrier board 13 and the semiconductor substrate 121 can be firmer, and a warping phenomenon caused by match of coefficients of thermal expansion is avoided. A reason is as follows: If a difference between a coefficient of thermal expansion of the support carrier board 13 and a coefficient of thermal expansion of the semiconductor substrate 121 is large, in a bonding craft process, under an effect of a high temperature, an expansion degree of the support carrier board 13 and an expansion degree of the semiconductor substrate 121 are different. After the bonding craft is completed and the temperature is restored to a room temperature, the support carrier board 13 and the semiconductor substrate 121 shrink to different degrees. As a result, a bonding location between the support carrier board 13 and the semiconductor substrate 121 changes, and consequently, a bonding effect between the support carrier board 13 and the semiconductor substrate 121 is poor. In addition, the chip packaging structure warps due to a force between the support carrier board 13 and the semiconductor substrate 121.

During specific implementation, step S302 may include: as shown in FIG. 9, forming a bonding layer 14 on a surface on a side of the support carrier board 13 by using a metal material or an oxide material. For example, the oxide material may be a silicon oxide material. Then, each die 12 is bonded to the support carrier board 13 by using the bonding layer 14, to obtain a structure shown in FIG. 10. In an actual craft process, the die 12 may be bonded to the surface of the support carrier board 13 by using a craft such as metal eutectic bonding (metal bonding), fusion bonding (fusion bonding), or hybrid bonding (hybrid bonding). Certainly, the die 12 may alternatively be fixed on the surface of the support carrier board 13 in another manner. This is not limited herein.

During actual application, an alignment mark for marking a location of the die may be disposed on the surface that is of the support carrier board and that faces the die. In this way, in a process in which the die is bonded to the surface of the support carrier board, the die can be more accurately bonded to a corresponding coordinate location by using the alignment mark, to improve precision of die bonding.

In another embodiment of this application, step S302 may include: forming an adhesive layer 14' on a surface on a side of the support carrier board 13 by using a chip adhesive film or a debonding adhesive; and adhering each die 12 to the support carrier board 13 by using the adhesive layer 14'. In other words, the bonding layer 14 may be replaced with the adhesive layer 14', and the die 12 may also be firmly fixed on the surface of the support carrier board 13 by disposing the adhesive layer 14'.

In this embodiment of this application, step S303 may include: as shown in FIG. 11, forming the plastic packaging layer 15 on a surface that is of the support carrier board 13 and that has the die 12, where the plastic packaging layer 15 fills a gap between adjacent dies 12, and the plastic packaging layer 15 wraps outer edges of all the dies 12 in the chip packaging structure. In other words, the gap between the adjacent dies 12 is filled with the plastic packaging layer 15, and an outer edge of a die 12 that is close to an outer side in the chip packaging structure is also wrapped by the plastic packaging layer 15. In this way, the plastic packaging layer 15 can reduce stress at an edge of the chip packaging structure, and further improve structural reliability of the chip packaging structure.

Optionally, the plastic packaging layer 15 may be manufactured by using epoxy molding compound (epoxy molding compound, EMC). Certainly, the plastic packaging layer 15 may alternatively be manufactured by using another material. This is not limited herein.

As shown in FIG. 7, in this embodiment of this application, the plurality of conductive columns 123 are disposed on the active surface S1 of each die 12 in the chip packaging structure. The conductive column 123 may include a metal material. For example, the conductive column 123 may be a copper column. Certainly, another material with good conductive performance may alternatively be used for the conductive column 123. This is not limited herein.

In step S303, refer to FIG. 11. The formed plastic packaging layer 15 fills a gap between adjacent conductive columns 123. Still refer to FIG. 11. After step S303, the foregoing manufacturing method may further include: removing the plastic packaging layer 15 from the surface of each die 12 in the plastic packaging structure, to expose the conductive column 123 on the surface of the die 12, and aligning a surface of the conductive column 123 with a surface of the plastic packaging layer 15, so that a surface of the plastic packaging structure is flat, to help subsequently form, on the surface of the plastic packaging structure, each film layer in the re-distribution layer. In this way, the die 12 may be electrically connected to the subsequently formed re-distribution layer by using the plurality of conductive columns 123.

Refer to FIG. 12. Step S304 may include: forming, on the surface of the die 12, each film layer in the re-distribution layer 11. For example, a metal layer may be formed, and the metal layer is graphed, to form a signal line in the re-distribution layer 11. In addition, a dielectric layer may further be formed between two adjacent metal layers. After each film layer in the re-distribution layer 11 is formed, a plurality of solder balls 16 may be further formed on a surface that is of the re-distribution layer 11 and that is away from the die 12. Subsequently, the re-distribution layer 11 may be electrically connected to a substrate 10 by using the plurality of solder balls 16.

Because the plurality of conductive columns 123 are disposed on the active surface S1 of the die 12, in an actual manufacturing process, a redundant plastic packaging material on the surface of the die 12 may be removed by using a grinding craft, to expose the conductive columns 123 on the surface of the die 12, and the surface of the conductive columns 123 is aligned with the surface of the plastic packaging layer 15, so that the surface of the plastic packaging structure 1000 is flat. Then, each film layer of the re-distribution layer 11 may be directly formed on the surface of the die 12. Therefore, the active surface S1 of the die 12 does not need to be welded to a surface of the re-distribution layer 11, so that a size of the conductive column 123 is not limited by a welding craft. A conductive column 123 of a smaller size may be disposed on the active surface S1 of the die 12, and the conductive columns 123 may be disposed more densely. For example, a distance between the conductive columns 123 may be less than 20 µm, to improve integration of the chip packaging structure.

During specific implementation, to prevent the die 12 from warping after being rigidly connected to the support carrier board 13, in a manufacturing craft process, a thickness of the die 12 and a thickness of the support carrier board 13 need to satisfy specified requirements. If the actual thickness of the die 12 and the actual thickness of the support carrier board 13 are different from a thickness required in a manufacturing craft, before the die 12 is fixed on the surface of the support carrier board 13 (that is, before step S302), the thickness of the die 12 and the thickness of the support carrier board 13 may be adjusted by using a thinning craft. The thinning craft includes but is not limited to the grinding craft. In addition, after the die 12 is fixed on the support carrier board 13 (for example, after step S304), the method may further include: thinning, by using the thinning craft, a surface that is of the support carrier board 13 and that is away from the die 12, to reduce a volume of the support carrier board 13, and ensure that a subsequently mounted protection cover can accommodate components such as the support carrier board 13 and the die 12. The thinning craft includes but is not limited to the grinding craft.

Refer to FIG. 4. In addition, after step S304, the method may further include: providing the substrate 10; and after the structure formed in FIG. 12 is turned over, fixing the re-distribution layer 11 on the substrate 10, where a surface that is of the re-distribution layer 11 and that is away from the die 12 faces the substrate 10. In this way, the re-distribution layer 11 is electrically connected to the substrate 10.

Still refer to FIG. 4. After the re-distribution layer 11 is fixed on the substrate 10, the method may further include: mounting the protection cover 18 on the substrate 10. The protection cover 18 is located on a side that is of the support carrier board 13 and that is away from the substrate 10, and there is a gap between the protection cover 18 and the support carrier board 13. Therefore, the protection cover 18 may have a function of protection and heat dissipation.

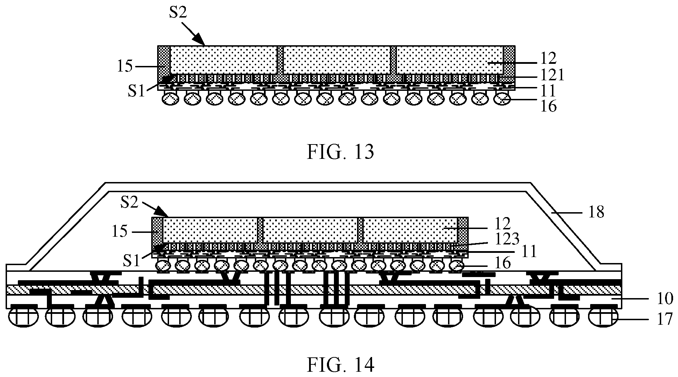

In another embodiment of this application, after step S304, the method may further include: removing the support carrier board by using a debonding craft, where the debonding craft includes but is not limited to the grinding craft, to obtain a structure shown in FIG. 13. In a craft process in which the plastic packaging layer, the re-distribution layer, and the like are formed, the support carrier board may have a function of fixing the die and supporting. After the re-distribution layer is formed, the support carrier board may be removed, to reduce a total thickness of the chip packaging structure and satisfy a requirement for lightness and thinness of the chip packaging structure.

Refer to FIG. 14. After the support carrier board is removed, the method may further include: fixing the re-distribution layer 11 on the substrate 10, where the surface that is of the re-distribution layer 11 and that is away from the die 12 faces the substrate 10; and then mounting the protection cover 18 on the substrate 10, where the protection cover 18 is located on a side that is of the die 12 and that is away from the substrate 10, and there is a gap between the protection cover 18 and the die 12. Therefore, the protection cover 18 may have the function of protection and heat dissipation.

Although some preferred embodiments of this application have been described, persons skilled in the art can make changes and modifications to these embodiments once they learn the basic inventive concept. Therefore, the following claims are intended to be construed as to cover the preferred embodiments and all changes and modifications falling within the scope of this application.

It is clear that persons skilled in the art can make various modifications and variations to embodiments of this application without departing from the spirit and scope of embodiments of this application. This application is intended to cover these modifications and variations provided that they fall within the scope of protection defined by the following claims and their equivalent technologies.

## Claims

1. A chip packaging structure, comprising a re-distribution layer, a plastic packaging structure wrapping at least two dies, and a support carrier board, wherein
the plastic packaging structure is fixed on the re-distribution layer, and the support carrier board is fixed on a side that is of the plastic packaging structure and that is away from the re-distribution layer; and
the support carrier board comprises a non-metal material, and the support carrier board is rigidly connected to each die in the plastic packaging structure.

2. The chip packaging structure according to claim 1, wherein the die comprises a semiconductor substrate and a distribution layer that is located on the semiconductor substrate; and
the support carrier board is rigidly connected to a surface that is of the semiconductor substrate and that is away from the distribution layer.

3. The chip packaging structure according to claim 2, wherein the semiconductor substrate comprises silicon, germanium, gallium arsenide, indium phosphide, gallium nitride, silicon carbide, or gallium oxide.

4. The chip packaging structure according to claim 1, further comprising a bonding layer located on a surface that is of the support carrier board and that faces the plastic packaging structure, wherein
each die in the plastic packaging structure is bonded to the support carrier board by using the bonding layer.

5. The chip packaging structure according to claim 4, wherein the bonding layer comprises a metal material or an oxide material.

6. The chip packaging structure according to claim 1, further comprising an adhesive layer located on a surface that is of the support carrier board and that faces the die, wherein
each of the at least two dies is adhered to the support carrier board by using the adhesive layer.

7. The chip packaging structure according to claim 6, wherein the adhesive layer comprises a chip adhesive film or a debonding adhesive.

8. The chip packaging structure according to any one of claims 1 to 7, wherein an alignment mark for marking a location of the die is disposed on the surface that is of the support carrier board and that faces the plastic packaging structure.

9. The chip packaging structure according to claim 1, wherein the plastic packaging structure comprises a plastic packaging layer filled between the support carrier board and the re-distribution layer, wherein the plastic packaging layer wraps the at least two dies, the plastic packaging layer fills a gap between adjacent dies of the at least two dies, and the plastic packaging layer wraps outer edges of the at least two dies.

10. The chip packaging structure according to claim 9, wherein a shape and a size of an external profile of the plastic packaging layer are consistent with a shape and a size of an external profile of the support carrier board.

11. The chip packaging structure according to any one of claims 1 to 10, wherein a plurality of conductive columns are disposed on a surface of each die in the plastic packaging structure; and
each die in the plastic packaging structure is electrically connected to the re-distribution layer by using the plurality of conductive columns.

12. The chip packaging structure according to any one of claims 1 to 11, further comprising a substrate, wherein
a plurality of solder balls are disposed on a surface that is of the re-distribution layer and that is away from the die, and the re-distribution layer is electrically connected to the substrate by using the plurality of solder balls.

13. The chip packaging structure according to any one of claims 1 to 12, wherein the support carrier board comprises at least two support substrates disposed in a stacked manner, wherein coefficients of thermal expansion of different support substrates in the support carrier board are different, and a difference between an average coefficient of thermal expansion of the support substrates in the support carrier board and a coefficient of thermal expansion of the die is less than a specified value.

14. The chip packaging structure according to any one of claims 1 to 13, wherein the support carrier board comprises silicon or silicon dioxide.

15. An electronic device, comprising a circuit board and the chip packaging structure according to any one of claims 1 to 14, wherein the chip packaging structure is electrically connected to the circuit board.

16. A manufacturing method of a chip packaging structure, wherein the method comprises:
providing at least two dies and a support carrier board, wherein the support carrier board comprises a non-metal material;
rigidly connecting each of the at least two dies to the support carrier board;
forming, by using a plastic packaging material, a plastic packaging layer that wraps the at least two dies, to form, on a surface of the support carrier board, a plastic packaging structure that wraps the at least two dies; and
forming a re-distribution layer on a side that is of the plastic packaging structure and that is away from the support carrier board.

17. The manufacturing method according to claim 16, wherein the rigidly connecting each of the at least two dies to the support carrier board comprises:
forming a bonding layer on a surface on a side of the support carrier board by using a metal material or an oxide material; and
bonding each of the at least two dies to the support carrier board by using the bonding layer.

18. The manufacturing method according to claim 16, wherein the rigidly connecting each of the at least two dies to the support carrier board comprises:
forming an adhesive layer on a surface on a side of the support carrier board by using a chip adhesive film or a debonding adhesive; and
adhering each of the at least two dies to the support carrier board by using the adhesive layer.

19. The manufacturing method according to any one of claims 16 to 18, wherein a plurality of conductive columns are disposed on a surface of each of the at least two dies;
the forming, by using a plastic packaging material, a plastic packaging layer that wraps the at least two dies comprises:
filling a gap between adjacent conductive columns by using the formed plastic packaging layer; and
after the plastic packaging structure is formed on the surface of the support carrier board, the method further comprises:
removing the plastic packaging layer from the surface of each die in the plastic packaging structure, to expose the conductive column on the surface of the die, and aligning a surface of the conductive column with a surface of the plastic packaging layer.
